# EUROPEAN PATENT APPLICATION

(11) **EP 2 779 232 A2**
(43) Date of publication of application: **17.09.2014**
(21) Application number: 14160005.6
(22) Date of filing: 14.03.2014
(51) Int. Cl.: H01L 23/488, H01L 23/49, H01L 21/60, H01L 23/31, H01L 23/495

(54) **Semiconductor device with a chip bonded to a lead frame with a sintered Ag layer, wherein a resin fillet covers the sintered Ag layer and a part of a side surface of the chip and wherein chip electrodes are bonded to leads, as well as method of manufacturing the same**

(30) Priority: 15.03.2013 JP 2013053812
(71) Applicant: Renesas Electronics Corporation, Kanagawa 211-8668 (JP)
(72) Inventor: Kajiwara, Ryoichi, Chiyoda-ku Tokyo 100-8280 (JP); Nakajo, Takuya, Kawasaki-shi Kanagawa 211-8668 (JP); Arai, Katsuo, Kawasaki-shi Kanagawa 211-8668 (JP); Yato, Yuichi, Kawasaki-shi Kanagawa 211-8668 (JP); Oka, Hiroi, Kawasaki-shi Kanagawa 211-8668 (JP); Hozoji, Hiroshi, Chiyoda-ku Tokyo 100-8280 (JP)
(74) Representative: Moore, Graeme Patrick

(57) **Abstract**

A semiconductor device (20, 24, 29, 32, 35, 38) includes a die pad (6), a wide gap semiconductor chip (SiC or GaN) (1) mounted on the die pad (6), a porous first sintered Ag layer (16) bonding the die pad (6) and the chip (1), and a reinforcing resin portion (17) covering a surface of the first sintered Ag layer (16) and a part of a side surface of the chip (1) and formed in a fillet shape. The semiconductor device (20, 24, 29, 32, 35, 38) further includes electrodes (1g, 1h, 2, 3, 4) on its main (1a) and back (1b) surfaces, the electrodes (1g, 1h, 2, 3, 4) being electrically connected to leads (7, 9, 11, 39), wherein the electrical connection at the front side is a wire (18, 19, 25, 26) connection and the electrical connection at the back side is the first sintered Ag layer (16). A porous second sintered Ag layer (36) or a second resin portion (30) reinforces the wire bonding portion on the electrode (1g, 2, 3). The semiconductor device (20, 24, 29, 32, 35, 38) further includes a sealing body (third resin) (14) which covers the chip (1), the first sintered Ag layer (16), and a part of the die pad (6).

## Description

### TECHNICAL FIELD

The present invention relates to a semiconductor device and a manufacturing method of the same and also relates to a technique effectively applied to a semiconductor device in which a sintered Ag layer is formed as a die bond material.

### BACKGROUND

Japanese Patent Application Laid-Open Publication No. 2009-94341 (Patent Document 1) discloses the structure in which a die bonding portion of a semiconductor device is metallically bonded by good conductive Cu metal powders having the maximum particle diameter in a range of about 15 µm to 200 µm and bonding layers of Ag and fine voids are homogeneously distributed in a connection layer.

Further, Japanese Patent Application Laid-Open Publication No. 2010-171271 (Patent Document 2) discloses the structure in which an Si chip and a lead frame are bonded by metal bonding via a bonding layer of a porous highly-conducting metal using Ag having three-dimensional network structure as a binder and a coating film containing oxide of Zn or Al is formed on a surface of a semiconductor assembly in contact with polymer resin.

Furthermore, Japanese Patent Application Laid-Open Publication No. 2011-249257 (Patent Document 3) describes a sintered silver paste material obtained by adding organic silver complex solution prone to be thermally decomposed regardless of atmosphere into sintered Ag paste and a semiconductor chip bonding method using the material.

### PRIOR ART DOCUMENTS

### PATENT DOCUMENTS

Patent Document 1: Japanese Patent Application Laid-Open Publication No. 2009-94341
Patent Document 2: Japanese Patent Application Laid-Open Publication No. 2010-171271
Patent Document 3: Japanese Patent Application Laid-Open Publication No. 2011-249257

### SUMMARY

Reduction in power consumption of an electronic device (semiconductor device) has been demanded in order to efficiently utilize limited resources/energy, and development of wide gap semiconductors such as silicon carbide (SiC) and gallium nitride (GaN) which are lower in loss than Si (silicon) as a power device has been advanced. Among them, the use of an SiC device (SiC chip) in a high-temperature range has been studied for the purpose of the simplification of a cooling system, and a package for mounting the device has been required to have high reliability during high-temperature operation.

However, a mounting technique which can ensure a high-temperature (200 to 250°C) operation of the SiC device for a long period of time has not been established under existing conditions. In a conventional embodiment of a high-temperature-proof mounting package mounted with an Si device (Si chip), a copper frame whose surface is Ni-plated is used as a lead frame, and a back surface electrode of the Si chip and a chip-mounting portion of the lead frame are bonded by high-temperature solder containing lead.

Further, a source electrode and a gate electrode on a surface (main surface) of the Si chip and respective lead terminals are connected to each other by ultrasonic bonding using aluminum (Al) wires, and encapsulation by transfer molding with sealing resin containing low thermal-expansion filler is done in a state where the Si chip, the aluminum wires, and the die bond portion are covered and the die pad of the lead frame and the lead terminals are partly exposed.

Note that, regarding the die bond structure, as disclosed in the above-described Patent Documents 1, 2 and 3, a bonding layer is made of porous sintered Ag as a bonding material (die bond material). The above-described Patent Documents 1 and 2 adopt a bonding structure in which a back surface electrode of the semiconductor chip and a chip-mounting surface of the die pad are composed of noble metal, a porous sintered Ag layer having a network structure of Ag in which fine voids are homogenously distributed at a rate of 5 to 70 vol% is used as the bonding layer, and the fine hole (porous) portions are filled with thermosetting resin.

Here, almost all of metal members (for example, lead frame and the like) for assembling a semiconductor device are made of copper (Cu) with high heat and electric conductivity, and in a case of the package requiring heat resistance, Ni-plating films are formed on various bonding surfaces in general.

In a resin sealing type package (semiconductor device), a semiconductor chip is die-bonded to the die pad plated with Ni by using a bonding layer made of lead solder having a thickness of 20 to 100 µm and an area around the semiconductor chip is covered with epoxy-sealing resin.

In a semiconductor device having the structure as described above, when a wide gap semiconductor chip is adopted as the semiconductor chip and an operation temperature thereof is increased to 200°C or higher, there is a possibility that large thermal strain is applied to a bonding portion of a soft lead solder between the semiconductor chip and the die pad due to separation between the lead frame and the sealing resin, a through-crack is formed in the bonding portion due to short repetitive temperature cycle, and electrical characteristic failure occurs early.

Furthermore, even if a structure in which bonding is achieved by using a sintered Ag layer like that disclosed in the above-described Patent Documents 1, 2 and 3 is adopted as an alternative technique of the lead solder, when the thickness of the bonding layer of the sintered Ag is small, large thermal strain is applied to the bonding portion of the sintered Ag due to a difference in thermal expansion between the semiconductor chip and the die pad, so that a through-crack is formed in a short period of time.

Although it is considered that the thickness of the bonding layer of the sintered Ag is increased in order to avoid the problem of the through-crack, it is necessary to increase the viscosity of sintered Ag paste to be used in order to make the bonding layer thick. At this time, a surface of a fillet made of sintered Ag paste pushed out from under the chip at the time of mounting the chip becomes uneven, stress concentration occurs in the vicinity of an end of the fillet close to the die pad after separation of the sealing resin, and it is likely to be the source of the occurrence of crack. For this reason, even if the bonding layer is made thick, a semiconductor device whose temperature cycle life is short is fabricated.

As a result, reliability of the semiconductor device is deteriorated.

An object of the embodiment disclosed in this application is to provide a technique capable of improving reliability of a semiconductor device.

The other problems and novel features will become apparent from the description of the specification and the accompanying drawings.

### MEANS FOR SOLVING THE PROBLEMS

A semiconductor device according to an embodiment includes: a chip-mounting portion; a wide gap semiconductor chip mounted on the chip-mounting portion; a porous first sintered Ag layer bonding the chip-mounting portion and the wide gap semiconductor chip; and a first resin portion covering a surface of the first sintered Ag layer and formed in a fillet shape, and the first resin portion covers a part of a side surface of the wide gap semiconductor chip.

### EFFECTS OF THE INVENTION

According to the embodiment, reliability of the semiconductor device can be improved.

### BRIEF DESCRIPTION OF THE DRAWINGS

FIG. 1 is a plan view showing one example of a structure of a semiconductor device of a first embodiment while illustrating a resin portion in a transparent manner;
FIG. 2 is a sectional view showing the structure taken along a line A-A shown in FIG. 1;
FIG. 3 is a partial schematic diagram showing one example of a structure of a surface of a sintered Ag layer at the time of forming the sintered Ag layer of the semiconductor device shown in FIG. 1;
FIG. 4 is a partial sectional view showing one example of a structure of a bonding layer at the time of forming a first resin portion of the semiconductor device shown in FIG. 1;
FIG. 5 is a partial sectional view showing a fillet shape of the bonding layer of the semiconductor device shown in FIG. 1;
FIG. 6 is a diagram showing an effect obtained by impregnating resin into the bonding layer of the semiconductor device shown in FIG. 1;
FIG. 7 is a flowchart showing one example of an assembling procedure of the semiconductor device shown in FIG. 1;
FIG. 8 is a plan view showing a structure of a semiconductor device of a first modified example of the first embodiment while illustrating a resin portion in a transparent manner;
FIG. 9 is a sectional view showing a structure taken along a line A-A shown in FIG. 8;
FIG. 10 is a flowchart showing one example of an assembling procedure of the semiconductor device shown in FIG. 8;
FIG. 11 is a sectional view showing a structure of a semiconductor device of a second modified example of the first embodiment;
FIG. 12 is a flowchart showing one example of an assembling procedure of the semiconductor device shown in FIG. 11;
FIG. 13 is a sectional view showing a structure of a semiconductor device of a third modified example of the first embodiment;
FIG. 14 is a flowchart showing one example of an assembling procedure of the semiconductor device shown in FIG. 13;
FIG. 15 is a plan view showing one example of a structure of a semiconductor device of a second embodiment while illustrating a resin portion in a transparent manner;
FIG. 16 is a sectional view showing a structure taken along a line A-A shown in FIG. 15;
FIG. 17 is a partial plan view showing one example of a structure of a wire bonding portion of a first electrode of a semiconductor chip of the semiconductor device shown in FIG. 15;
FIG. 18 is a partial sectional view showing a structure taken along a line A-A shown in FIG. 17;
FIG. 19 is a flowchart showing one example of an assembling procedure of the semiconductor device shown in FIG. 15;
FIG. 20 is a plan view showing a structure of a semiconductor device of a modified example of the second embodiment while illustrating a resin portion in a transparent manner; and
FIG. 21 is a sectional view showing a structure taken along a line A-A shown in FIG. 20.

### DETAILED DESCRIPTION

In the embodiments described below, the description of the same or similar portions is not repeated in principle unless particularly required.

Further, in the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof.

Also, in the embodiments described below, when referring to the number of elements (including number of pieces, values, amount, range, and the like), the number of the elements is not limited to a specific number unless otherwise stated or except the case where the number is apparently limited to a specific number in principle, and the number larger or smaller than the specified number is also applicable.

Further, in the embodiments described below, it goes without saying that the components (including element steps) are not always indispensable unless otherwise stated or except the case where the components are apparently indispensable in principle.

Also, even when mentioning that constituent elements or the like are "made of A" or "made up of A" in the embodiments below, elements other than A are of course not excluded except the case where it is particularly specified that A is the only element thereof. Similarly, in the embodiments described below, when the shape of the components, positional relation thereof, and the like are mentioned, the substantially approximate and similar shapes and the like are included therein unless otherwise stated or except the case where it is conceivable that they are apparently excluded in principle. The same goes for the numerical value and the range described above.

Hereinafter, embodiments of the present invention will be described in detail with reference to the accompanying drawings. Note that components having the same function are denoted by the same reference symbols throughout the drawings for describing the embodiments, and the repetitive description thereof will be omitted. Also, hatching is used in some cases even in a plan view so as to make the drawings easy to see.

### First Embodiment

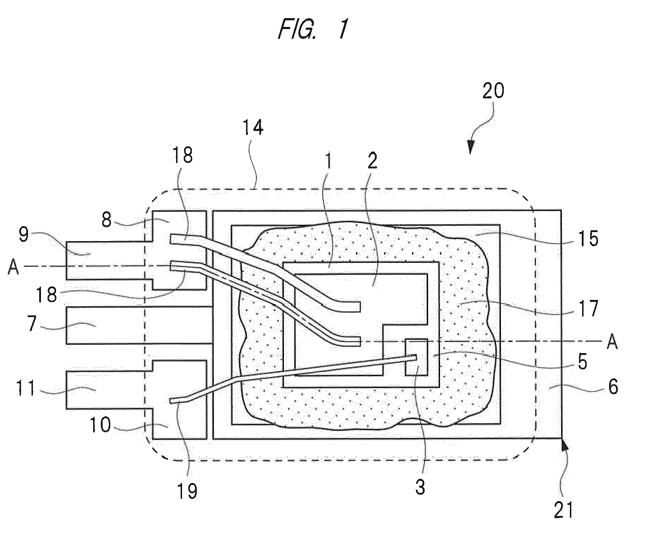

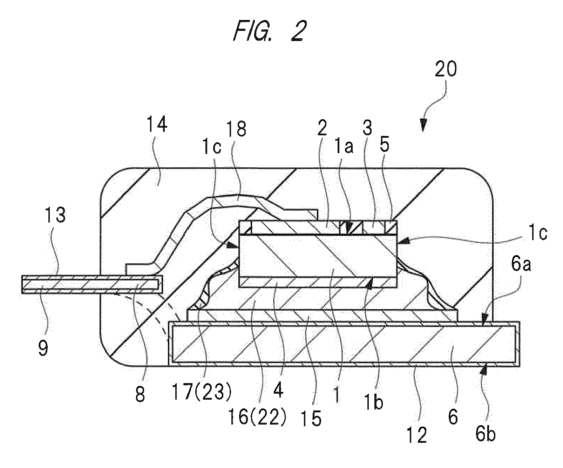

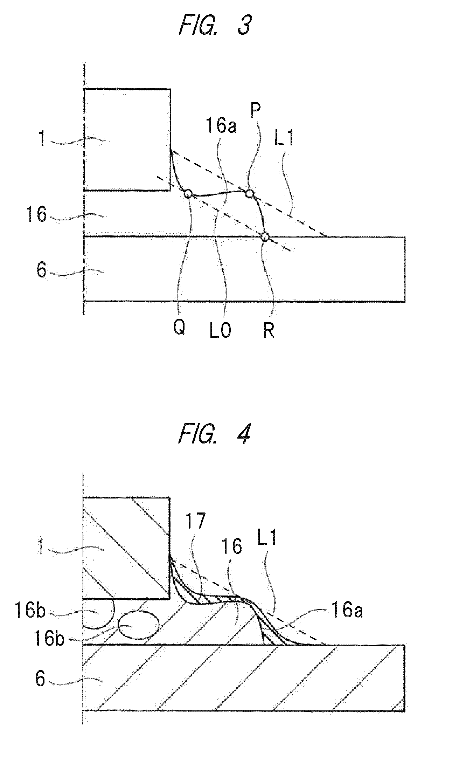

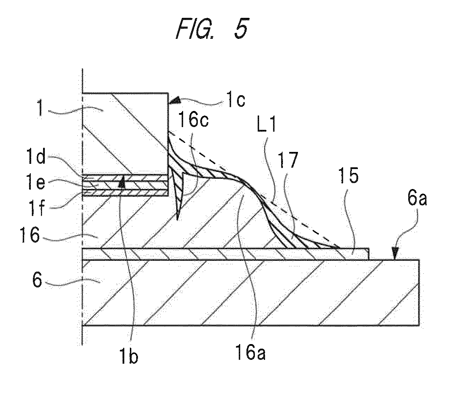

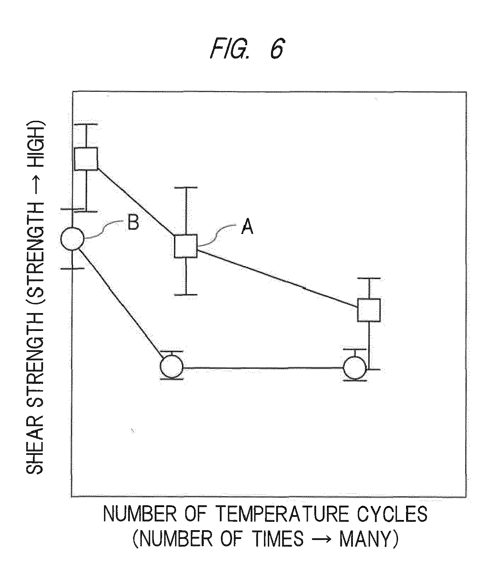

FIG. 1 is a plan view showing one example of a structure of a semiconductor device of a first embodiment while illustrating a resin portion in a transparent manner, FIG. 2 is a sectional view showing a structure taken along a line A-A shown in FIG. 1, FIG. 3 is a partial schematic diagram showing one example of a structure of a surface of a sintered Ag layer at the time of forming the sintered Ag layer of the semiconductor device shown in FIG. 1, and FIG. 4 is a partial sectional view showing one example of a structure of a bonding layer at the time of forming a first resin portion of the semiconductor device shown in FIG. 1. Further, FIG. 5 is a partial sectional view showing a fillet shape of the bonding layer of the semiconductor device shown in FIG. 1, and FIG. 6 is a diagram showing an effect obtained by impregnating resin into the bonding layer of the semiconductor device shown in FIG. 1.

In the semiconductor device of the first embodiment, a wide gap semiconductor chip operating in a high temperature range (200 to 250°C) is mounted. Note that the above-described wide gap semiconductor chip of the first embodiment is a vertical semiconductor chip having electrodes provided on a main surface and a back surface, respectively, and a case where a transistor device is mounted in a resin sealing type semiconductor package is described as an example in the first embodiment.

Further, as the above-described wide gap semiconductor chip, a semiconductor chip (also referred to as "SiC device") made of SiC (silicon carbide) will be described as an example in the first embodiment, but the above-described wide gap semiconductor chip may be a semiconductor chip made of GaN (gallium nitride) or the like.

As shown in FIG. 1 and FIG. 2, in a semiconductor package (semiconductor device) 20 of the first embodiment, an SiC chip (wide gap semiconductor chip) 1 which is an SiC device is mounted. The SiC chip 1 has a main surface 1a, a back surface 1b on an opposite side thereof, and four side surfaces 1c disposed at positions between the main surface 1a and the back surface 1b, and the main surface 1a has a size of, for example, 2.5 mm x 2.5 mm. Further, the thickness of the SiC chip 1 is, for example, 0.35 mm.

Furthermore, a source electrode (first electrode) 2 serving as a main electrode having an outermost surface composed of an Al (aluminum) film is formed on the main surface 1a of the SiC chip 1, and a drain electrode (second electrode) 4 with a multi-layered structure having an outermost surface composed of an Au (gold) or Ag (silver) film is formed on the back surface 1b. Note that a gate electrode (third electrode) 3 having an area smaller than that of the source electrode 2 is formed on the main surface 1a, and an outermost surface of the gate electrode 3 is also composed of an Al film.

Moreover, a passivation film 5 serving as a protection film is formed between the electrodes of the main surface 1a and on an outer circumferential portion of the chip.

The SiC chip 1 like this is mounted on an upper surface (chip-mounting surface) 6a of a die pad 6 serving as a chip-mounting portion.

Note that, in the semiconductor package 20 of the first embodiment, a porous first sintered Ag layer 16 which bonds the die pad 6 and the SiC chip 1 is provided as a die bond material between the upper surface 6a of the die pad 6 and the SiC chip 1.

Further, the source electrode 2 on the main surface 1a of the SiC chip 1 is electrically connected to a source lead (first lead) 9 via a wire made of aluminum (hereinafter, referred to as aluminum wire) 18 serving as one example of a metal wire. At this time, the aluminum wire 18 is electrically connected to a source bond pad 8 formed integrally with the source lead 9, and since a relatively large current is applied to the source electrode 2 in the semiconductor package 20 of the first embodiment, the source electrode 2 and the source lead 9 are electrically connected to each other by two aluminum wires 18.

In addition, the gate electrode 3 on the main surface 1a is electrically connected to a gate lead (third lead) 11 via an aluminum wire 19 thinner than the aluminum wire 18. At this time, the aluminum wire 19 is electrically connected to a gate bond pad 10 formed integrally with the gate lead 11.

On the other hand, the drain electrode 4 on the back surface 1b is electrically connected to the die pad 6 via the first sintered Ag layer 16, and is further electrically connected to a drain lead (second lead) 7 formed integrally with the die pad 6.

Note that, in the semiconductor package 20, the die pad 6, the source lead 9, the source bond pad 8, the drain lead 7, the gate lead 11, and the gate bond pad 10 are made of a material containing Cu (copper) as a main component. Furthermore, Ni-plating films 12 are formed on the respective surfaces of the die pad 6 and the drain lead 7, and Ni-plating films 13 are formed also on the respective surfaces of the source lead 9, the source bond pad 8, the gate lead 11, and the gate bond pad 10. More specifically, the Ni-plating films are formed on the respective surfaces of the respective lead members including the die pad 6.

Therefore, the source electrode 2 on the main surface 1a of the SiC chip 1 and the source bond pad 8 having the Ni-plating film 13 are electrically connected to each other by the ultrasonic bonding of the two aluminum wires 18. Further, the gate electrode 3 on the main surface 1a and the gate bond pad 10 having the Ni-plating film 13 are electrically connected to each other by the ultrasonic bonding of the aluminum wire 19.

Further, an Ag-plating film (first noble metal plating film) 15 is formed on the Ni-plating film 12 on the surface of the chip-mounting region of the upper surface 6a of the die pad 6. Here, the film thickness of the Ni-plating film 12 is, for example, 2.0 µm and the film thickness of the Ag-plating film 15 is, for example, 5.0 µm. However, these film thicknesses are not limited to these numerical values, and they can be selected arbitrarily.

Note that the respective surfaces of the aluminum wires 18 and 19 may be covered with second noble metal plating films such as an Au film or an Ag film, so that respective connection strengths at connection portions between the aluminum wires 18 and 19 and the electrodes of the SiC chip 1 and connection portions with respective leads can be enhanced.

Here, in the semiconductor package 20 of the first embodiment, the SiC chip 1 is mounted on the die pad 6 via the porous first sintered Ag layer 16 formed by sintering sintered Ag paste with high viscosity under a pressureless condition. At this time, since the drain electrode 4 with a multi-layered structure having an outermost surface composed of an Au or Ag film is formed on the back surface 1b of the SiC chip 1 and the Ag-plating film 15 is formed on the upper surface 6a of the die pad 6, the Au or Ag film of the drain electrode 4 on the back surface 1b is metal-bonded to the Ag-plating film 15 on the die pad 6.

Note that the thickness of the first sintered Ag layer 16 used as the die bond material must be 50 µm or more, and it is here set to 150 µm. Further, a porosity of the porous first sintered Ag layer 16 is adjusted in a range of 20 to 60 vol%, and it is here set to, for example, 40 vol%. Note that, in the drain electrode 4 on the back surface 1b of the SiC chip 1, the interdiffusion reaction with sintered Ag is less likely to occur, so that the multi-layered structure thereof maintains its initial state.

Furthermore, in the semiconductor package 20 of the first embodiment, a reinforcing resin portion (first resin portion) 17 which is made of polyamide resin or polyimide resin formed by applying and curing liquid resin or high temperature-resistance epoxy resin whose glass transition temperature is 190°C or higher is formed on the first sintered Ag layer 16 and in the vicinity thereof.

More specifically, the reinforcing resin portion 17 is formed so as to cover a surface of the first sintered Ag layer 16 over an entire periphery of the SiC chip 1 when seen in a plan view, and is formed in a fillet shape with respect to the Ag-plating film 15 on the upper surface 6a of the die pad 16.

Further, the reinforcing resin portion 17 covers parts of the respective side surfaces 1c of the SiC chip 1. More specifically, the reinforcing resin portion 17 is formed in the fillet shape, an upper end portion of the fillet reaches the respective side surfaces 1c of the SiC chip 1, and the reinforcing resin portion 17 has also a function as a protection layer of the first sintered Ag layer 16.

Note that the resin for forming the reinforcing resin portion 17 is impregnated also into some of the hole portions of the first sintered Ag layer 16 and the strength (rigidity) of the first sintered Ag layer 16 is enhanced, but it is not impregnated into all of the hole portions of the first sintered Ag layer 16.

Further, in the semiconductor package 20, the SiC chip 1, the aluminum wires 18 and 19, the first sintered Ag layer 16, the reinforcing resin portion 17, the source bond pad 8, the gate bond pad 10 and a part of the die pad 6 are covered with a sealing body (third resin portion) 14.

More specifically, the sealing body 14 is formed so as to cover the entire structure so that the lower surface 6b of the die pad 6 and parts of the respective leads (source lead 9, drain lead 7, gate lead 11) are exposed, and the lower surface 6b of the die pad 6 is exposed on the mounting surface side of the sealing body 14. Note that the sealing body 14 is made of epoxy-based thermosetting resin or the like.

Next, the reinforcing resin portion 17 provided in the semiconductor package 20 of the first embodiment will be described in detail with reference to FIG. 3 to FIG. 5.

In the structure shown in FIG. 3, the SiC chip 1 is metal-bonded to the die pad 6 having the Ag-plating film 15 shown in FIG. 5 formed thereon by the porous first sintered Ag layer 16 formed by baking the paste composed of Ag particles with a particle diameter of 0.5 to 2.0 µm. Note that the first sintered Ag layer 16 forms fillet portions 16a on the outer circumference of the SiC chip 1.

As shown in FIG. 3, in the sectional shape of the fillet portion 16a, an uneven shape is formed by the sintered Ag paste with high viscosity which has been pushed out from under the chip, and since sintering progresses while maintaining an initial state of the fillet portion 16a in the sintering process, a projection portion P is formed.

By applying liquid resin to the fillet portion 16a and curing the same and impregnating the resin into the porous first sintered Ag layer 16, the first sintered Ag layer 16 impregnated with resin is formed as shown in FIG. 4, and the reinforcing resin portion 17 is simultaneously formed on the fillet portion 16a of the first sintered Ag layer 16 in a state where much resin is concentrated in a recessed portion by the effect of surface tension.

As shown in FIG. 3, the thickness of the reinforcing resin portion 17 of FIG. 4 on the fillet portion 16a is set to a thickness of 1/4 or more of a distance from a second straight line L1 to the fillet portion 16a or the die pad 6 based on the second straight line L1 obtained by translating a first straight line L0 corresponding to the lowermost straight line among the straight lines connecting two points Q and R on the fillet portion 16a on both sides of the projection portion P to a tip end of the projection portion P of the fillet portion 16a. Further, the thickness of the resin layer at the most recessed portion from the second straight line L1 on the fillet portion 16a is set to 10 µm or more.

Note that, as shown in FIG. 4, when the liquid resin is applied and curing process of the resin is further performed, unfilled portions 16b in which the resin has not entered also exist in the first sintered Ag layer 16.

Further, FIG. 5 shows a structure in which the reinforcing resin portion 17 is formed on the fillet portion 16a of the first sintered Ag layer 16 in which an initial vertical crack 16c exists in the vicinity of a chip side surface. As shown in FIG. 5, a contact film 1d made of titanium or the like, a base film 1e made of nickel or the like, and a noble metal film 1f made of Au, Ag or the like are formed on the back surface 1b of the SiC chip 1.

Furthermore, an Ag-plating film 15 is formed in the chip-mounting region on the upper surface 6a of the die pad 6, and the SiC chip 1 and the die pad 6 are bonded to each other by the first sintered Ag layer 16. Note that the initial vertical crack 16c formed in the course of sintering exists in the fillet portion 16a of the first sintered Ag layer 16 on the side surface 1c of the SiC chip 1, and the reinforcing resin portion 17 is formed inside the vertical crack 16c, in the region on the first sintered Ag layer 16 recessed from the second straight line L1 defined above and on the surface of the first sintered Ag layer 16.

In more detail, when the semiconductor chip is disposed on the die pad 6 at a die bond process, the sintered Ag paste pushed out tends to form a recessed portion in a region near the chip side surface and form a crack in a vertical direction (vertical crack 16c) in the vicinity of the chip side surface due to a volumetric shrinkage in the course of paste sintering, so that the initial vertical crack 16c at the time of package completion weakens the reinforcing effect of the bonding portion by the fillet.

As a result, the separation of the sealing resin occurs, which causes the problem of the reduction in resistance in a temperature cycle test of the bonding portion performed thereafter.

Furthermore, the initial vertical crack 16c causes the problem of the reduction in moisture resistance reliability of the electrode on the chip back surface.

In view of this, the structure of the semiconductor package 20 of the first embodiment is reinforced by die-bonding the SiC chip 1 and the die pad 6 made of Cu alloy with the first sintered Ag layer 16 having a thickness of about 150 µm and filling the recessed portion of the fillet portion 16a of the first sintered Ag layer 16 formed in a projection shape and the vertical crack 16c in the vicinity of the side surface 1c of the SiC chip 1 with high-heat-resistance and high-strength resin.

In this manner, even if the operation temperature of the SiC chip 1 reaches a high temperature in a range of 200 to 250°C and the sealing resin (sealing body 14) is separated from the die pad 6, thermal stress generated due to a difference in thermal expansion between SiC and Cu is not concentrated on a specific portion of the fillet portion 16a of the first sintered Ag layer 16, so that a crack generation timing in the fillet portion 16a can be delayed.

As a result, reliability in the temperature cycle test of the die bond portion (bonding portion between the SiC chip 1 and the die pad 6) can be significantly improved, and the reliability of the semiconductor package 20 can be improved.

Further, since the reinforcing resin portion 17 covers a part of the side surface 1c of the SiC chip 1, the degree of adhesion between the SiC chip 1 and the reinforcing resin portion 17 can be increased. More specifically, since an adhesion strength between SiC (silicon carbide) and sintered Ag is not so high, the degree of adhesion between the SiC chip 1 and the reinforcing resin portion 17 can be increased because of the upper end portion of the fillet of the reinforcing resin portion 17 reaching the side surface 1c of the SiC chip 1, and the separation at an interface between the SiC chip 1 and the first sintered Ag layer 16 can be suppressed.

As a result, reliability of the semiconductor package 20 can be improved.

Furthermore, even if the vertical crack 16c is formed in the vicinity of the chip side surface of the fillet portion 16a of the first sintered Ag layer 16, since the vertical crack 16c, an upper portion of the fillet portion 16a and hole portions inside the first sintered Ag layer 16 in the vicinity thereof are filled with the reinforcing resin portion 17, it is possible to prevent the direct contact of moisture with an interface of a multi-layered electrode film on the chip side surface.

More specifically, even if the sealing resin (sealing body 14) separates from the die pad 6 and external air with high humidity enters an area around the fillet portion 16a, since moisture is prevented from coming into direct contact with the interface of the multi-layered electrode film of the chip side surface, the separation by the reduction in the strength of the interface of the multi-layered electrode film due to the action of oxidation, corrosion or the like can be prevented, so that the reduction in moisture resistant reliability of the die bond portion can be suppressed.

Further, since the resin of the reinforcing resin portion 17 is embedded into the vertical crack 16c of the first sintered Ag layer 16, external air or moisture entering through the vertical crack 16c can be reduced and the reduction in the moisture-resistant reliability of the electrode on the back surface 1b of the SiC chip 1 can be suppressed.

Furthermore, since the semiconductor package 20 has a structure in which liquid resin is impregnated into the porous first sintered Ag layer 16 and a surface of porous internal Ag skeleton is covered with the resin, even if the semiconductor package 20 is held at a high temperature of 250°C for a long period of time of several thousand hours, the organization change of the sintered Ag due to surface diffusion of Ag is suppressed, so that high-temperature reliability of the die bond portion can be improved.

Here, FIG. 6 shows the shear strengths measured when temperature cycles have been performed a desired number of times in the case A in which resin (for example, epoxy-based resin) is impregnated into hole portions in the porous sintered Ag layer used as the die bond material and in the case B in which no resin is impregnated. As shown in FIG. 6, a result that shear strength of the porous sintered Ag layer with respect to the number of temperature cycles becomes higher in the case A in which resin is impregnated into hole portions than in the case B in which no resin is impregnated into hole portions is obtained.

From the above, by forming the die bond portion from the porous first sintered Ag layer 16 having a thickness of 150 µm and covering a stress-concentrated portion of the recessed portion of the fillet portion 16a of the first sintered Ag layer 16 with the high-temperature-resistance and high-strength reinforcing resin portion 17 having a thickness of 10 µm or more to reinforce the semiconductor package, reliability can be enhanced even in the semiconductor package 20 in which the SiC chip 1 operating in a high-temperature range of 200 to 250°C is mounted.

More specifically, it is possible to realize the semiconductor package 20 in which the SiC chip 1 operating in a high temperature range of 200 to 250°C is mounted and the die bond portion excellent in temperature cycle reliability, high-temperature and high-humidity reliability and high-temperature reliability is provided.

As a result, the resin sealing type semiconductor package 20 excellent in reliability for a long period of time can be realized.

Note that the thickness of the first sintered Ag layer 16 shown in FIG. 2 can be made larger than 500 µm by increasing the viscosity of the sintered Ag paste, but an upper limit thereof is set to 400 µm considering the material cost. Note that, when the bonding thickness is 50 µm or less, since required temperature cycle reliability cannot be obtained even if sufficient resin reinforcement is performed, the lower limit thereof is set to 50 µm.

Further, in the semiconductor package 20 of the first embodiment, since the first sintered Ag layer 16 has the porous structure, the thermal strain generated by a difference in thermal expansion from the SiC chip 1 can be absorbed by its own low elastic characteristic, and it is possible to avoid the bonding interface between the electrode on the back surface 1b and the sintered Ag layer from being damaged by the thermal fatigue breakdown or the like.

Further, since it is possible to avoid the bonding interface between the electrode on the back surface 1b of the SiC chip 1 and the sintered Ag layer from being damaged by the thermal fatigue breakdown or the like, a current conduction route between the die pad 6 and the SiC chip 1 can be secured. Therefore, even if high-temperature operation at a temperature higher than 200°C is repeated, occurrence of failure due to rapid breaking at the above-described bonding portion of the electrode can be prevented, so that reliability as a long-lasting package product can be secured.

Further, in the structure shown in FIG. 2, the reinforcing resin portion 17 is composed of one layer, but a two-layered structure may be adopted by forming a polyimide-based first reinforcing resin portion excellent in adhesion with metal on the sintered Ag layer and further forming an epoxy-based second reinforcing resin portion thereon. In the above-described two-layered structure, it becomes easy to make each layer matched with a material in contact therewith or adjust the thickness of the layer to an optimal thickness, and higher reliability can be obtained in the semiconductor device by adopting the two-layered structure.

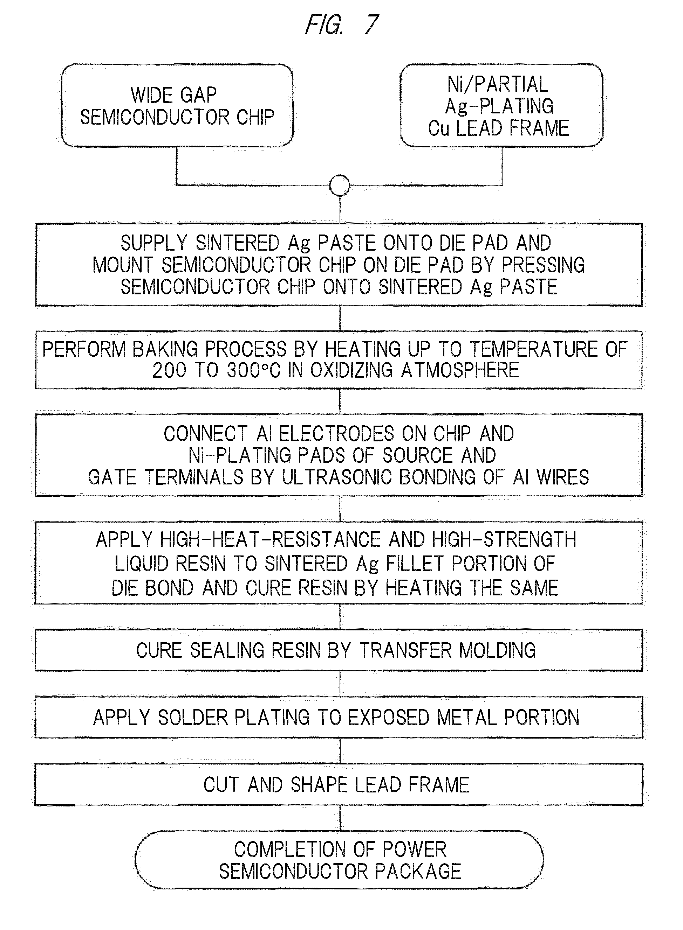

Next, assembling of the semiconductor device (semiconductor package 20) of the first embodiment will be described. FIG. 7 is a flowchart showing one example of an assembling procedure of the semiconductor device shown in FIG. 1.

Here, the assembling procedure will be described along the flowchart shown in FIG. 7 with reference to FIG. 1 and FIG. 2.

First, as members, a lead frame 21 in which its entire surface is plated with Ni and Ag plating is partly performed thereon and a vertical SiC chip (wide gap semiconductor chip) 1 in which a noble metal film of Au, Ag or the like is formed on a surface of a drain electrode 4 on a back surface 1b and respective surfaces of a source electrode 2 and a gate electrode 3 on a main surface 1a are composed of Al films are prepared.

Here, the lead frame 21 is provided with a die pad 6 having an upper surface 6a, a source lead 9 and a gate lead 11 disposed in the vicinity of the die pad 6, and a drain lead 7 coupled to the die pad 6 and formed integrally with the die pad 6.

Next, first sintered Ag paste (sintered Ag paste) 22 containing fine Ag particles and volatile solvent as main components is supplied onto an Ag-plating region of the upper surface 6a of the die pad 6 of the lead frame 21 by a dispenser so as to correspond to the size of the chip to be mounted. At this time, the first sintered Ag paste 22 is supplied so as to form a pattern with which the first sintered Ag paste 22 to be pushed out when the SiC chip 1 is mounted and is pushed in forms fillets having the same size at chip corners and at chip sides, for example, a pattern having dots of the paste at five points corresponding to chip corners and a central portion of the chip.

Further, when the SiC chip 1 is mounted, it is pushed so as to have a predetermined height from the upper surface 6a of the die pad 6 by a mounter. At this time, the amount of the first sintered Ag paste 22 to be supplied is controlled to such an extent that a chip lower surface is entirely embedded with the first sintered Ag paste 22 and the side surfaces 1c of the SiC chip 1 are embedded up to the middle with the pushed-out part of the first sintered Ag paste 22. If the supply of the first sintered Ag paste 22 is too much, the sintered Ag comes around up to the main surface (upper surface) 1a of the SiC chip 1 and when it is too little, a fillet having a sufficient size cannot be formed. Therefore, the above-described proper amount of the first sintered Ag paste 22 is supplied.

After the chip is mounted, baking process of the first sintered Ag paste 22 is performed in a temperature range of 200 to 300°C, for example, at a temperature of 250°C for one hour under a pressureless condition in a baking furnace of an air atmosphere, thereby forming a first sintered Ag layer 16. Note that the solvent component and organic components having fine Ag particles attached to the surfaces thereof disappear in the heating process due to volatilization or decomposition caused by thermal decomposition and oxidation, and coupling between particles by the surface diffusion of Ag at the positions in which fine Ag particles come into contact with each other starts to form a network of Ag, so that the SiC chip 1 and the die pad 6 are metallically bonded to each other via the porous network of Ag in the first sintered Ag layer 16.

Next, the source electrode 2 whose surface is composed of an Al film on the chip and the source band pad 8 of the source lead 9 on which an Ni-plating film 13 is formed are connected to each other by ultrasonic bonding using thick aluminum wires 18. Further, the gate electrode 3 whose surface is composed of an Al film and the gate bond pad 10 of the gate lead 11 on which the Ni-plating film 13 is formed are similarly connected to each other by ultrasonic bonding using a thin aluminum wire 19.

More specifically, the source electrode 2 on the main surface 1a of the SiC chip 1 and the source lead 9 are electrically connected to each other via the thick aluminum wires 18 by ultrasonic bonding, and the gate electrode 3 on the main surface 1a and the gate lead 11 are electrically connected to each other via the aluminum wire 19 thinner than the aluminum wire 18 by ultrasonic bonding.

Next, reinforcing resin (first resin) 23 which is first high-heat-resistance and high-strength liquid resin is supplied (applied) by a dispenser onto a surface of the first sintered Ag layer 16 which is the sintered Ag fillet of the die bond portion. At this time, the reinforcing resin 23 is supplied so that the reinforcing resin 23 is impregnated into the porous first sintered Ag layer 16 and a resin layer of the reinforcing resin 23 has a predetermined thickness or more in a recessed portion on the fillet.

At this time, the reinforcing resin 23 is supplied so as to cover parts of the respective side surfaces 1c of the SiC chip 1. More specifically, the reinforcing resin 23 is supplied so that an upper end portion (end portion on the chip side) of the fillet of the reinforcing resin 23 reaches the respective side surfaces 1c of the SiC chip 1.

After the reinforcing resin 23 is supplied, heating process is performed to cure the reinforcing resin 23 under an optimal curing condition in conformity to the supplied reinforcing resin 23, thereby forming a reinforcing resin portion 17 covering a surface of the first sintered Ag layer 16 and forming the fillet.

In this manner, the reinforcing resin portion 17 is formed so as to cover respective parts of the side surfaces 1c of the SiC chip 1. More specifically, the reinforcing resin portion 17 is formed so that the upper end portion (end portion on the chip side) of the fillet of the reinforcing resin portion 17 reaches the respective side surfaces 1c of the SiC chip 1.

Next, after the mounted lead frame 21 is set in a resin molding die, encapsulation by transfer molding with epoxy-based sealing resin containing low thermal-expansion filler is done, and curing process is performed by holding the mounted lead frame 21 while heating the same, thereby forming a sealing body 14.

After the resin sealing, solder plating is applied to metal-exposed portions (here, source lead 9, drain lead 7 and gate lead 11) if necessary. However, it is not always necessary to form the above-described solder plating.

Next, a semiconductor package 20 which is a power semiconductor package is completed by cutting and shaping the lead frame 21. More specifically, assembling of the semiconductor package 20 is completed by cutting and separating the source lead 9, the drain lead 7 and the gate lead 11 from the lead frame 21 and desirably bending these leads.

According to the manufacturing method of a semiconductor device of the first embodiment, since a structure in which the high-heat-resistance and high-strength reinforcing resin portion 17 is formed at a stress-concentrated portion of the die bond portion composed of the sintered Ag layer can be manufactured by the process applicable to the mass production, it becomes possible to assemble the high-reliability resin sealing type semiconductor package 20 in which a fault such as characteristic failure does not occur for a long period of time even if the operation temperature of the SiC chip 1 is in a high-temperature range of 200 to 300°C. At this time, it is possible to mass-produce the semiconductor package 20 of the first embodiment with a productivity equivalent to that of the conventional product.

Note that, in the first embodiment, the case where the reinforcing resin 23 for die bond reinforcement is applied and cured after the wire bonding has been described, but the process of applying and curing the reinforcing resin 23 may be performed after the die bonding (before wire bonding). In particular, in a product in which resin reinforcement is not performed to the wire bonding portion or a product in which reinforcement is performed by a metal member, productivity is almost the same even when any of these processes is adopted.

Further, a process of performing heating UV irradiation to oxidize an Ag-plating surface may be added before supplying the first sintered Ag paste 22 to the lead frame 21 in which partial Ag plating has been applied to the die pad 6 and the bond pad. When the heating UV irradiation process is performed, organic contamination on the surface of the lead frame 21 can be decomposed and removed and the surface can be cleaned, and also the oxide film of Ag plating is changed to nanoparticles when it is reduced at a sintering temperature of the sintered Ag paste to serve to facilitate sintering bonding with Ag particles in the paste. Therefore, bonding strength between the sintered Ag layer and the lead frame can be further enhanced.

Moreover, it is also possible that the process of applying and curing the reinforcing resin 23 is stopped at a semi-cured state and the main curing of the reinforcing resin 23 is performed at the process of curing the epoxy-based sealing resin. When the sealing resin is molded while the reinforcing resin 23 being in a semi-cured state, an adhesion force between the reinforcing resin 23 and the sealing resin is improved and the sealing resin in the vicinity of the fillet is prevented from separating from the die pad 6 or the sintered Ag layer, so that reliability in the temperature cycle test of the die bond portion can be further improved.

Next, modified examples of the first embodiment will be described.

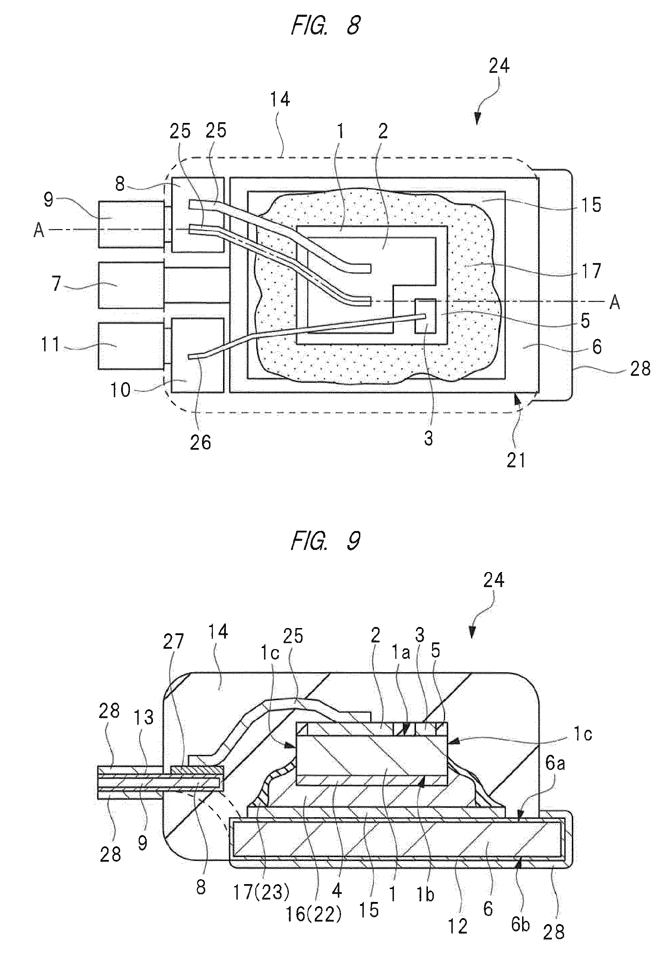

FIG. 8 is a plan view showing a structure of a semiconductor device of a first modified example of the first embodiment while illustrating a resin portion in a transparent manner, and FIG. 9 is a sectional view showing a structure taken along a line A-A shown in FIG. 8.

The first modified example shown in FIG. 8 and FIG. 9 shows a semiconductor package 24 having a structure approximately similar to that of the semiconductor package 20 shown in FIG. 1 and FIG. 2 of the first embodiment, and only a different point between the semiconductor package 24 and the semiconductor package 20 will be described here.

In the semiconductor package 24 of the first modified example, first, copper wires (one example of metal wires, wires made of copper (Cu)) 25 and 26 having noble metal plating films such as an Au film or an Ag film formed on the surfaces thereof are used as wires electrically connecting the SiC chip 1 and the leads, and the respective wires are connected by ultrasonic bonding. Alternatively, Ag wires (one example of metal wires, wires made of silver (Ag)) may be used instead of the copper wires 25 and 26 having noble metal plating films such as an Au film or an Ag film formed on the surfaces thereof.

Here, the case where the copper wires 25 and 26 having noble metal plating films such as an Au film or an Ag film formed on the surfaces thereof are used will be described. More specifically, wires electrically connecting the source electrode 2 of the SiC chip 1 and the source lead 9 are thick copper wires 25, and a wire electrically connecting the gate electrode 3 of the SiC chip 1 and the gate lead 11 is a copper wire 26 thinner than the copper wire 25, and heat resistances of the respective wires and the wire bonding portions are enhanced.

Also, surfaces of the copper wires 25 and 26 are covered with noble metal plating films such as an Au film or an Ag film. Since the copper wires 25 and 26 whose surfaces are covered with noble metal plating films can be connected by ultrasonic bonding, these wires have advantages of excellent mass productivity.

Further, respective outermost surfaces of the source electrode 2 and the gate electrode 3 of the main surface 1a of the SiC chip 1 are composed of noble metal plating films such as an Ni/Au film or an Ag film, and therefore connectivity between the copper wires 25 and 26 whose surfaces are covered with noble metal plating films such as an Au film or an Ag film and the source electrode 2 and the gate electrode 3 is enhanced.

Furthermore, since the copper wires 25 and 26 whose surfaces are covered with noble metal plating films such as an Au film or an Ag film are used, Ag plating 27 is formed on respective pad surfaces of the source bond pad 8 of the source lead 9 to which the copper wire 25 is connected and the gate bond pad 10 of the gate lead 11 to which the copper wire 26 is connected.

In this manner, connectivity between the copper wires 25 and 26 whose surfaces are covered with noble metal plating films such as an Au film or an Ag film and the above-described respective pads can be enhanced.

Further, solder plating 28 is formed on the respective surfaces of metal portions exposed from the sealing body 14, that is, a part including the lower surface 6b of the die pad 6, the source lead 9, the drain lead 7, and the gate lead 11. Note that, since an edge surface of each lead has been subjected to cutting process, respective sections of the copper lead of the core, the Ni plating, and the solder plating are exposed on the edge surface.

Since the other structure of the semiconductor package 24 of the first modified example is similar to that of the semiconductor package 20 of the first embodiment, the redundant description thereof is omitted.

Since the semiconductor package 24 of the first modified example has the same die bond structure as that of the semiconductor package 20 shown in FIG. 1, it is possible to obtain the effect of the long-term reliability of the die bond portion similar to that obtained in the semiconductor package 20 shown in FIG. 1.

Further, since the source electrode 2 and the source lead 9 through which a large current flows are connected by ultrasonic bonding of the Ag or Cu wire having higher electric and heat conductivity and lower thermal expansion than those of the aluminum wire, heat generated from the wire itself can be reduced and temperature rising of the wire bond portion can be suppressed by the improvement in heat dissipation capacity from the surface of the SiC chip 1.

As a result, reliability in the temperature cycle test of the wire bonding portion can be improved, and power loss of the semiconductor package 24 can be reduced, so that a high-performance and high-reliability resin sealing type semiconductor package 24 can be realized.

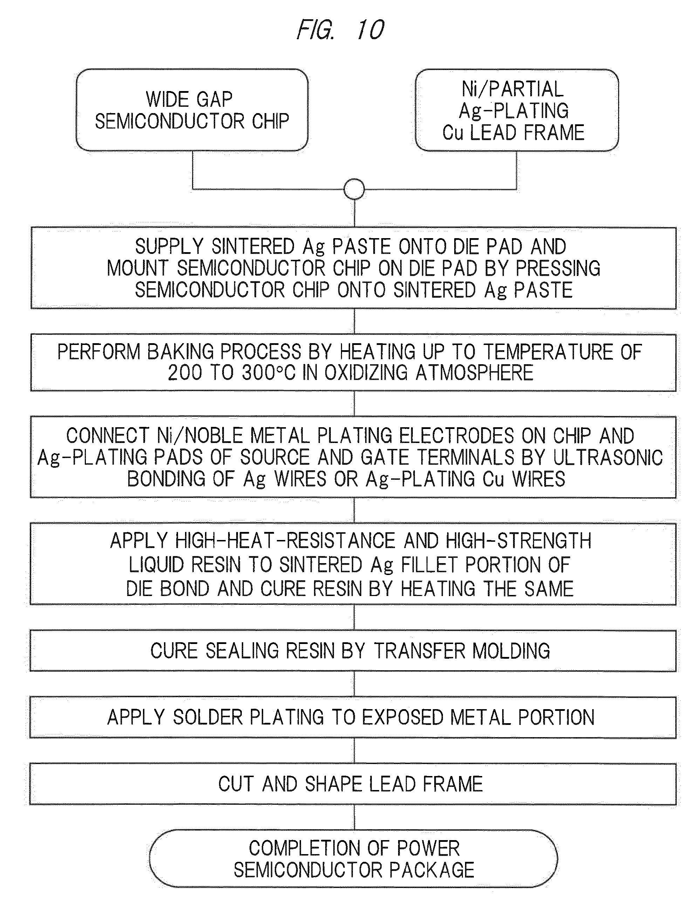

Next, assembling of the semiconductor package 24 of the first modified example will be described. FIG. 10 is a flowchart showing one example of an assembling procedure of the semiconductor device (semiconductor package 24) shown in FIG. 8. Since assembling of the semiconductor package 24 is almost identical to that of the semiconductor package 20 shown in FIG. 7, only a different point will be described with reference to FIG. 8 to FIG. 10.

The different point between the assembling of the semiconductor package 24 and that of the semiconductor package 20 lies in only the wire bonding process.

At the wiring bonding process in the assembling of the semiconductor package 24, first, the source electrode 2 positioned on the main surface 1a of the SiC chip 1 and having an outermost surface composed of a noble metal plating film such as an Ni/Au film or an Ag film and the source bond pad 8 of the source lead 9 to which an Ag plating 27 is applied are connected to each other by ultrasonic bonding by using an Ag wire or a thick copper wire 25 to which a noble metal plating film such as an Ag film is applied.

Further, the gate electrode 3 having an outermost surface composed of a noble metal plating film such as an Ni/Au film or an Ag film and the gate bond pad 10 of the gate lead 11 to which an Ag plating 27 is applied are connected to each other by ultrasonic bonding by using an Ag wire or a copper wire 26 which is thinner than the copper wire 25 and to which a noble metal plating film such as an Ag film is applied.

In this manner, also in the wire bonding of the semiconductor package 24, the source electrode 2 and the source lead 9 can be connected by using the copper wires 25, and further the gate electrode 3 and the gate lead 11 can be connected by using the copper wire 26.

Since an effect similar to that in the assembling of the semiconductor package 20 shown in FIG. 7 can be obtained also in the assembling of the semiconductor package 24 of the first modified example, the redundant description thereof is omitted.

Next, a second modified example of the first embodiment will be described.

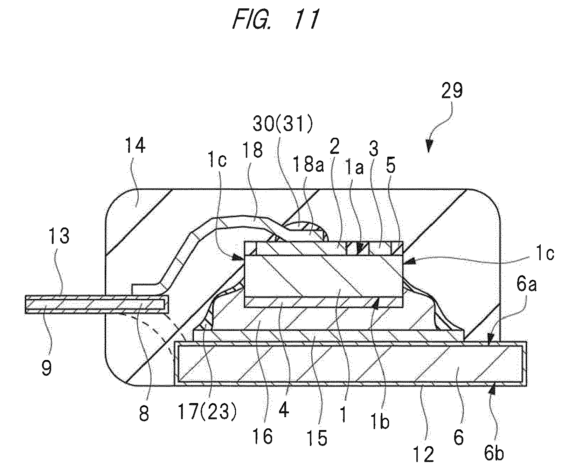

FIG. 11 is a sectional view showing a structure of a semiconductor device of a second modified example of the first embodiment.

The second modified example shown in FIG. 11 shows a semiconductor package 29 having a structure approximately similar to that of the semiconductor package 20 shown in FIG. 1 and FIG. 2 of the first embodiment, and only a different point between the semiconductor package 29 and the semiconductor package 20 will be described here.

In the semiconductor package 29 of the second modified example shown in FIG. 11, the source electrode 2 on the main surface 1a of the SiC chip 1 and the source lead 9 are electrically connected to each other by an aluminum wire 18, and the wire bonding portion with the aluminum wire 18 is covered with a reinforcing resin portion (second resin portion) 30 on the source electrode 2.

More specifically, since the wire bonding portion of the source electrode 2 on the main surface 1a of the SiC chip 1 and a peripheral portion thereof are covered with the reinforcing resin portion 30 and the part around a tip end portion of the wire bonding portion including a gap-shaped notch portion 18a is embedded in the reinforcing resin portion 30, the connection of the wire bonding portion of the aluminum wire 18 is reinforced to enhance the connection strength.

Note that it is preferred that the reinforcing resin portion 30 is made of high-temperature-resistance and high-strength imide-based resin excellent in adhesive property with aluminum. By this means, since stress concentration to an end portion of a bonding interface of the aluminum wire 18 can be reduced and the imide-based resin is excellent in adhesion with epoxy sealing resin, a pressing force caused by the shrinkage of the reinforcing resin portion 30 is applied to the wire bonding portion of the aluminum wire 18, so that the reduction in the crack occurrence and the crack growth rate in the wire bonding portion can be achieved.

As a result, reliability in a power cycle test of the wire bonding portion of the aluminum wire 18, high-temperature and high-humidity reliability of the die bond portion, and reliability in the temperature cycle test can be improved, so that the resin sealing type semiconductor package 29 excellent in long-term reliability can be realized.

Note that, since the other structure and the other effect of the semiconductor package 29 are similar to those of the semiconductor package 20 of the first embodiment, the redundant reduction thereof is omitted.

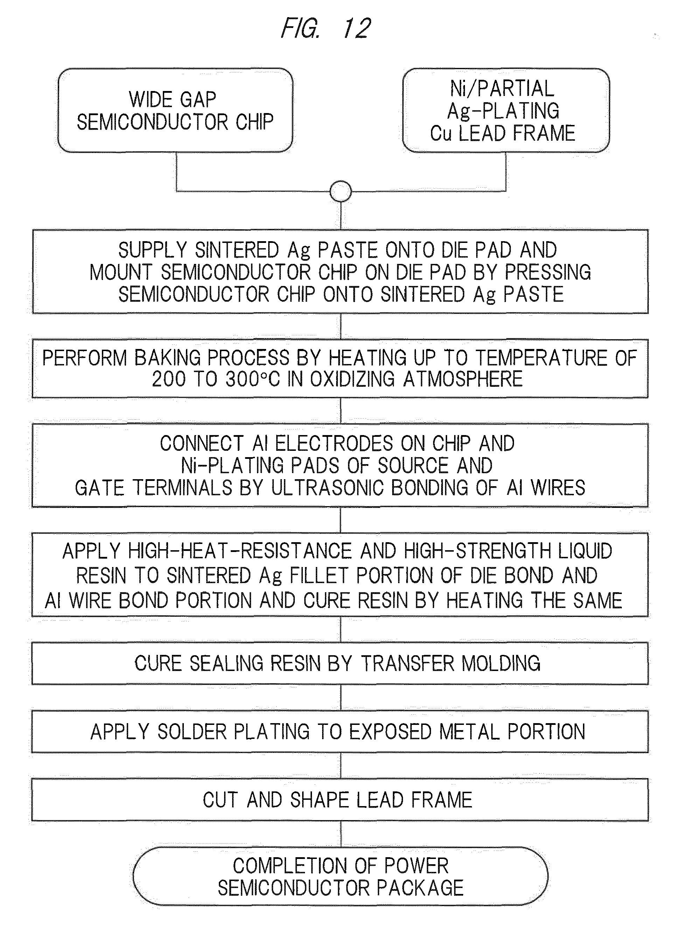

Next, assembling of the semiconductor package 29 of the second modified example will be described. FIG. 12 is a flowchart showing one example of an assembling procedure of the semiconductor device shown in FIG. 11. Since assembling of the semiconductor package 29 is almost identical to that of the semiconductor package 20 shown in FIG. 7, only a different point therebetween will be described with reference to FIG. 11 and FIG. 12.

The different point between the assembling of the semiconductor package 29 and that of the semiconductor package 20 lies in only the resin-applying and resin-curing process.

More specifically, at the resin-applying and resin-curing process after the wire bonding by ultrasonic bonding, high-temperature-resistance and high-strength liquid resin is applied onto the first sintered Ag layer 16 and the wire bonding portion of the aluminum wire 18, and the resin is heated and cured.

Specifically, the reinforcing resin 23 is applied (supplied) onto the first sintered Ag layer 16, and the reinforcing resin 23 is impregnated into the hole portions in the first sintered Ag layer 16. Further, reinforcing resin (second resin) 31 is applied (supplied) onto the wire bonding portion of the source electrode 2, and thereafter the reinforcing resin 23 and the reinforcing resin 31 are heated, thereby forming the reinforcing resin portion 17 covering the first sintered Ag layer 16 and the reinforcing resin layer 30 covering the wire bonding portion of the aluminum wire 18 on the source electrode 2.

Therefore, the reinforcing resin 23 and the reinforcing resin 31 are high-heat-resistance and high-strength liquid resin and are preferably the same resin, but it is not always necessary that they are the same resin.

Note that, in the wire bonding portion on the source electrode 2, the reinforcing resin 31 is applied so that the part around a tip end portion including the gap-shaped notch portion 18a between the aluminum wire 18 and the electrode film (wire bonding portion) is embedded in the reinforcing resin portion 30, thereby forming the reinforcing resin portion 30.

In the assembling of the semiconductor package 29 of the second modified example, a structure in which the high-heat-resistance and high-strength reinforcing resin portion 17 and reinforcing resin portion 30 are formed at respective stress-concentrated portions in the die bond portion composed of the sintered Ag layer and in the wire bonding portion of the aluminum wire 18 on the SiC chip 1 can be manufactured by the process applicable to the mass production. As a result, it becomes possible to assemble the high-reliability resin sealing type semiconductor package 29 in which a fault such as characteristic failure does not occur for a long period of time even if the operation temperature of the SiC chip 1 is in a high-temperature range of 200 to 300°C. Moreover, it is possible to mass-produce the semiconductor package 29 with a productivity equivalent to that of the conventional product.

Note that, since the other manufacturing method and the other effect in the assembling of the semiconductor package 29 are similar to those in the assembling of the semiconductor package 20 of the first embodiment, the redundant description thereof is omitted.

Next, a third modified example of the first embodiment will be described.

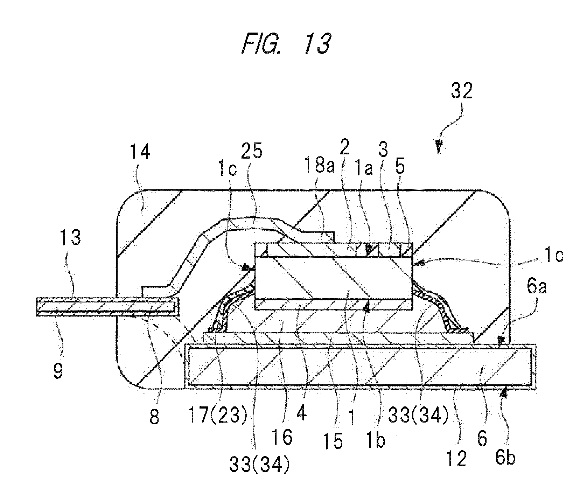

FIG. 13 is a sectional view showing a structure of a semiconductor device of the third modified example of the first embodiment.

The third modified example shown in FIG. 13 shows a semiconductor package 32 having a structure approximately similar to that of the semiconductor package 20 shown in FIG. 1 and FIG. 2 of the first embodiment, and only a different point between the semiconductor package 32 and the semiconductor package 20 will be described here.

In the semiconductor package 32 of the third modified example, an organic Zn film 33 such as an oxidized Zn film is formed at least at an interface between the first sintered Ag layer 16 and the reinforcing resin portion 17, thereby improving adhesion strength between the reinforcing resin portion 17 and the metal members (first sintered Ag layer 16 and Ag-plating film 15).

In more detail, the organic Zn film 33 is formed on respective surfaces of the first sintered Ag layer 16 and the Ag plating film 15 on the die pad 6 which are the metal members, and reinforcing resin 23 is applied onto the organic Zn film 33 and then heated and cured, thereby forming the reinforcing resin portion 17.

The organic Zn film 33 is formed by applying organic Zn compound solution 34 to the first sintered Ag layer 16 and heating and baking the organic Zn compound solution 34 at a temperature of 200 to 350°C in the atmosphere. Since the organic Zn compound solution 34 has low viscosity, it penetrates into the hole portions in the first sintered Ag layer 16 to be formed also on the surfaces of Ag inside the first sintered Ag layer 16, so that the organic Zn film 33 which comes in close contact with respective metal surfaces is formed regardless of metal species such as Ag and Ni. At this time, though depending on the applied amount or Zn content in the applied solution, the organic Zn film 33 is formed to have a film thickness in a range of several nm to several hundred nm.

Further, in the semiconductor package 32, as a wire electrically connecting the SiC chip 1 and a lead, a copper wire 25 having a noble metal plating film such as an Au film or an Ag film formed on the surface thereof is used, and the copper wire 25 is connected by ultrasonic bonding. Note that an Ag wire may be used instead of the copper wire 25 having a noble metal plating film such as an Au film or an Ag film formed on the surface thereof.

Also, the surface of the copper wire 25 is covered with a noble metal plating film such as an Au film or an Ag film.

Further, the respective outermost surfaces of the source electrode 2 and the gate electrode 3 on the main surface 1a of the SiC chip 1 are composed of a noble metal plating film such as an Ni/Au film or an Ag film, and therefore connectivity between the copper wire 25 whose surface is covered with a noble metal plating film such as an Au film or an Ag film and the source electrode 2 or the gate electrode 3 is enhanced.

According to the semiconductor package 32 of the third modified example, since the organic Zn film 33 is provided, adhesion strength between the first sintered Ag layer 16 and a peripheral metal surface thereof and the reinforcing resin portion 17 can be enhanced and the separation can be prevented. Therefore, even when a resin of an external sealing body 14 separates, formation of a crack in the first sintered Ag layer 16 can be prevented by the protection effect of the reinforcing resin portion 17.

As a result, the semiconductor package 32 provided with the high-heat-resistance die bond structure excellent in reliability in the temperature cycle test and high-temperature and high-humidity reliability can be realized.

Note that, since the other structure and the other effect of the semiconductor package 32 are similar to those of the semiconductor package 20 of the first embodiment, the redundant description thereof is omitted.

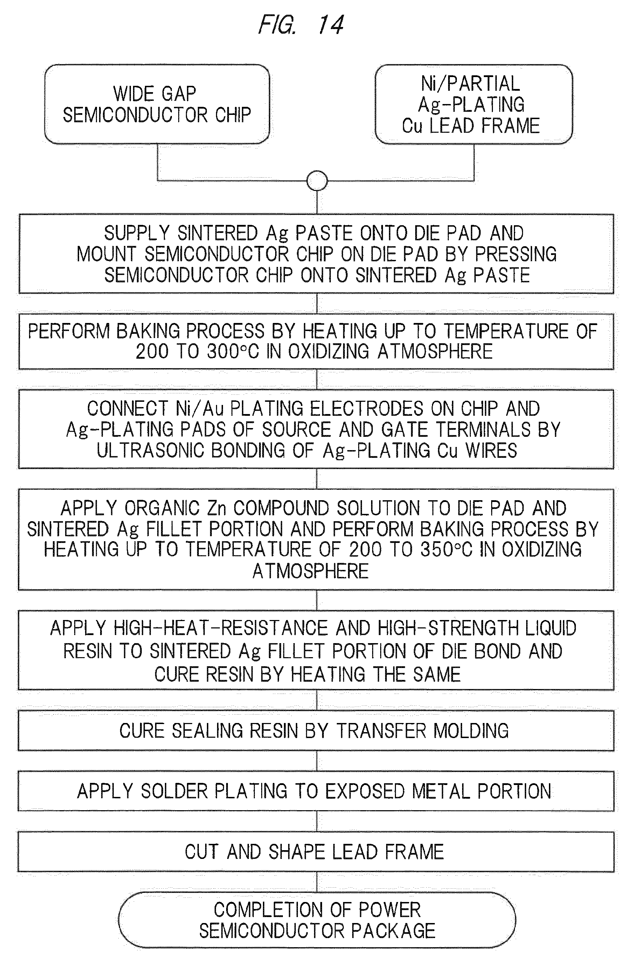

Next, assembling of the semiconductor package 32 of the third modified example will be described. FIG. 14 is a flowchart showing one example of an assembling procedure of the semiconductor device shown in FIG. 13. Since assembling of the semiconductor package 32 is almost identical to that of the semiconductor package 20 shown in FIG. 7, only a different point therebetween will be described with reference to FIG. 13 and FIG. 14.

The different point between the assembling of the semiconductor package 32 and the assembling of the semiconductor package 20 lies in the wire bonding process and the process of forming an organic Zn film provided before the resin-applying and resin-curing process after the wire bonding process.

First, at the wire bonding process, the source electrode 2 positioned on the main surface 1a of the SiC chip 1 and having a noble metal plating film (for example, Ni/Au film) formed thereon and the source lead 9 are connected (electrically connected) by ultrasonic bonding by using the copper wire 25 plated with Ag (or Ag wire), and similarly the gate electrode 3 and the gate lead 11 (see FIG. 8) are connected (electrically connected) by ultrasonic bonding by using the copper wire 25.

After the wire bonding, the organic Zn film is formed before the resin-applying and resin-curing process.

At the process of forming the organic Zn film, organic Zn compound solution 34 is applied (supplied) onto the die pad 6 and the first sintered Ag layer 16, and the baking process is performed by heating the organic Zn compound solution 34 to a temperature of 200 to 350°C in an oxidizing atmosphere. In this manner, an organic Zn film 33 such as an organic oxide film is formed on the fillet portion 16a of the first sintered Ag layer 16, an Ag skeleton surface inside thereof, and the surface of the Ag-plating film 15 (and Ni-plating film 12) on the upper surface 6a of the die pad 6.

After the formation of the organic Zn film, the resin-applying and resin-curing process similar to the resin-applying and resin-curing process in the assembling of the semiconductor package 20 shown in FIG. 7 is performed to form the reinforcing resin portion 17 covering the first sintered Ag layer 16.

Note that, since the other manufacturing method and the other effect in the assembling of the semiconductor package 32 are similar to those in the assembling of the semiconductor package 20 of the first embodiment, the redundant description thereof is omitted.

### Second Embodiment

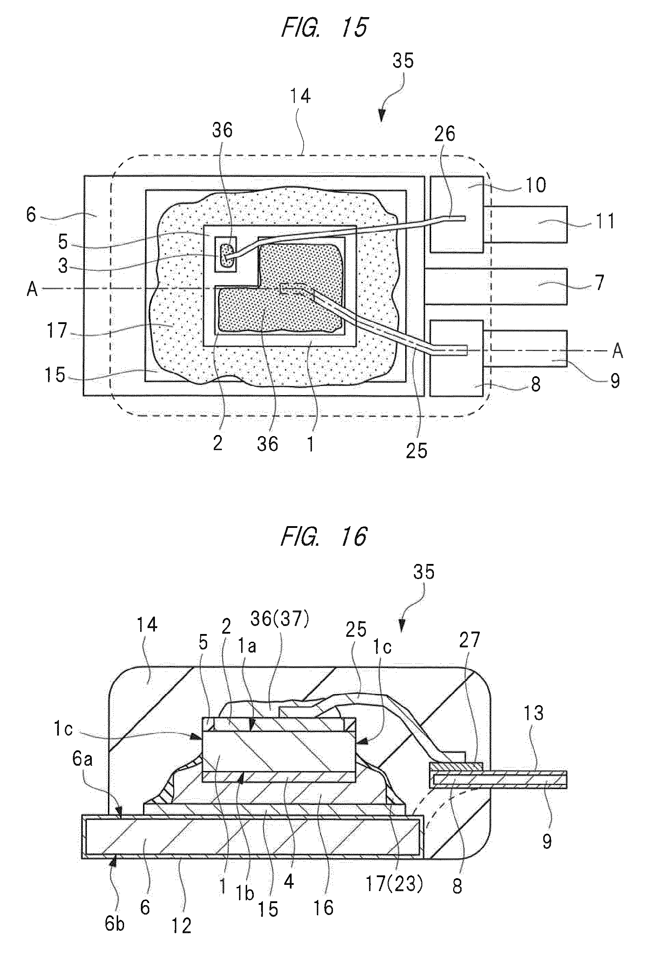

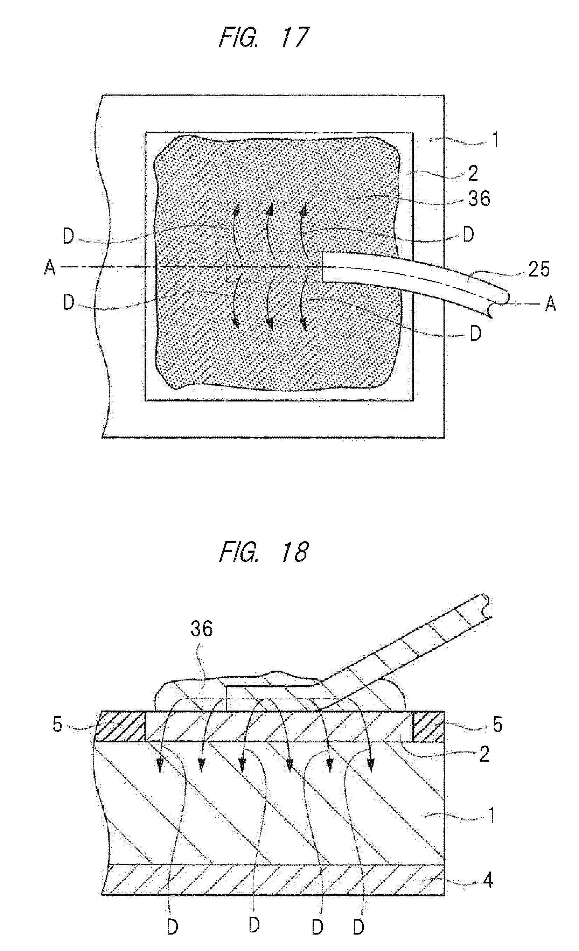

FIG. 15 is a plan view showing one example of a structure of a semiconductor device of the second embodiment while illustrating a resin portion in a transparent manner, FIG. 16 is a sectional view showing a structure taken along a line A-A shown in FIG. 15, FIG. 17 is a partial plan view showing one example of a structure of a wire bonding portion of a first electrode of a semiconductor chip of the semiconductor device shown in FIG. 15, and FIG. 18 is a partial sectional view showing a structure taken along a line A-A shown in FIG. 17.

A semiconductor package (semiconductor device) 35 of the second embodiment shown in FIG. 15 and FIG. 16 has a structure approximately similar to that of the semiconductor package 20 shown in FIG. 1 and FIG. 2 of the first embodiment, and only a different point between the semiconductor package 35 and the semiconductor package 20 will be described here.

In the semiconductor package 35 of the second embodiment, first, copper wires 25 and 26 having noble metal plating films such as an Au film or an Ag film formed on the surfaces thereof are used as wires electrically connecting the SiC chip 1 and the leads, and the respective wires are connected by ultrasonic bonding. Alternatively, Ag wires may be used instead of the copper wires 25 and 26 having noble metal plating films such as an Au film or an Ag film formed on the surfaces thereof.

Here, the case where the copper wires 25 and 26 having noble metal plating films such as an Au film or an Ag film formed on the surfaces thereof are used will be described. More specifically, wires electrically connecting the source electrode 2 of the SiC chip 1 and the source lead 9 are thick copper wires 25, and a wire electrically connecting the gate electrode 3 of the SiC chip 1 and the gate lead 11 is a copper wire 26 thinner than the copper wire 25, and heat resistances of the respective wires and the wire bonding portions are enhanced.

Also, surfaces of the copper wires 25 and 26 are covered with noble metal plating films such as an Au film or an Ag film. Since the copper wires 25 and 26 whose surfaces are covered with noble metal plating films can be connected by ultrasonic bonding, these wires have advantages of excellent mass productivity.

Further, respective outermost surfaces of the source electrode 2 and the gate electrode 3 of the main surface 1a of the SiC chip 1 are composed of noble metal plating films such as an Ni/Au film or an Ag film, and therefore connectivity between the copper wires 25 and 26 whose surfaces are covered with noble metal plating films such as an Au film or an Ag film and the source electrode 2 and the gate electrode 3 is enhanced.

Furthermore, since the copper wires 25 and 26 whose surfaces are covered with noble metal plating films such as an Au film or an Ag film are used, Ag plating 27 is formed on respective pad surfaces of the source bond pad 8 of the source lead 9 to which the copper wire 25 is connected and the gate bond pad 10 of the gate lead 11 to which the copper wire 26 is connected.

In this manner, connectivity between the copper wires 25 and 26 whose surfaces are covered with noble metal plating films such as an Au film or an Ag film and the above-described respective pads can be enhanced.

Furthermore, on the source electrode 2 serving as a main electrode on the main surface 1a of the SiC chip 1, a porous second sintered Ag layer 36 having a thickness of 30 µm or more is formed in the state of covering (a part of) the wire bonding portion of the copper wire 25 and covering 70% or more of the surface of the source electrode 2, preferably an almost entire surface region (whole surface) thereof.

Note that the second sintered Ag layer 36 preferably covers the whole surface of the source electrode 2, but it may be formed so as to cover an inner region other than the outer circumferential portion of the surface of the source electrode 2 as shown in FIG. 15. More specifically, since it is difficult to control the second sintered Ag layer 36 so as to cover all 100% of the surface of the source electrode 2, the second sintered Ag layer 36 may be formed so as to cover the inner region other than the outer circumferential portion in order to prevent the protrusion from the outer circumferential portion of the surface.

Further, in the semiconductor package 35, the porous second sintered Ag layer 36 is formed also on the wire bonding portion on the surface of the gate electrode 3 on the main surface 1a of the SiC chip 1 so as to cover the wire bonding portion.

According to the semiconductor package 35 of the second embodiment, since the source electrode 2 and the source lead 9 for source electrode through which a large main current flows are connected to each other by the copper wire 25 having a small electrical resistance and excellent in heat conductivity, heat generation in the wire itself is small and heat dissipation capacity to the lead side is large in comparison to the aluminum wire, so that temperature rising of the wire bonding portion can be suppressed.

Furthermore, since the porous second sintered Ag layer 36 excellent in heat and electrical conductivities is formed on an approximately whole surface (entire surface) of the source electrode 2 so as to cover the wire bonding portion, current D supplied from the copper wire 25 is dispersed and uniformly supplied to the SiC chip (SiC device) 1 through the low-resistance sintered Ag layer (second sintered Ag layer 36).

In this manner, a heat generation distribution becomes uniform in the SiC chip 1, and the occurrence of local overheating can be suppressed.

Further, since the occurrence of local overheating can be suppressed, a risk of cell damage in the device is reduced, and failure occurrence due to the device can be reduced.

Moreover, since the second sintered Ag layer 36 excellent in heat conductivity is formed on the source electrode 2 serving as the main electrode, even when heat generation becomes large in the wire bonding portion on the source electrode 2, the heat can be instantaneously distributed to a surrounding area of the wire bonding portion, so that the temperature rising of the wire bonding portion can be suppressed.

Further, since the temperature rising of the wire bonding portion is suppressed by the suppression of heat generation of the wire itself, uniformization of heat generation in the device, and a heat-distribution effect by the second sintered Ag layer 36, crack growth due to thermal fatigue of the wire bonding portion can be delayed. As a result, improvement in life of the power cycle test regarding breaking of the wire bonding portion can be achieved.

Furthermore, the porous second sintered Ag layer 36 is metal-bonded to the copper wire 25 to which noble metal plating is applied, and it is metal-bonded also to the noble metal plating film on the surface of the source electrode 2.

Therefore, even when breaking of the bonding interface between the copper wire 25 and the source electrode 2 progresses due to thermal fatigue caused by the difference in thermal expansion therebetween, breaking at the bonding interface between the porous second sintered Ag layer 36 and the source electrode 2 does not occur because the sintered Ag having a low elastic modulus absorbs strain, and breaking at the bonding interface between the copper wire 25 and the second sintered Ag layer 36 also does not occur.

In this manner, since a path of the current D supplied from the copper wire 25 can be secured by the sintered Ag layer (second sintered Ag layer 36), the high-reliability semiconductor package 35 which can maintain a product performance for a long period of time can be realized.

Further, since the semiconductor package 35 of the second embodiment has the same die bond structure as the semiconductor package 20 shown in FIG. 1, it is possible to obtain the effect of the long-term reliability of the die bond portion similar to that obtained in the semiconductor package 20 shown in FIG. 1.

Further, since the source electrode 2 and the source lead 9 through which a large current flows are connected by ultrasonic bonding of the Ag or the copper wire 25 having higher electric and heat conductivity and lower thermal expansion than those of the aluminum wire, heat generated from the wire itself can be reduced and temperature rising of the wire bond portion can be suppressed by the improvement in heat dissipation capacity from the surface of the SiC chip 1.

As a result, reliability in the temperature cycle test of the wire bonding portion can be improved, and power loss of the semiconductor package 35 can be reduced, so that a high-performance and high-reliability resin sealing type semiconductor package 35 can be realized.

Since the other structure and the other effect of the semiconductor package 35 of the second embodiment are similar to those of the semiconductor package 20 of the first embodiment, the redundant description thereof is omitted.

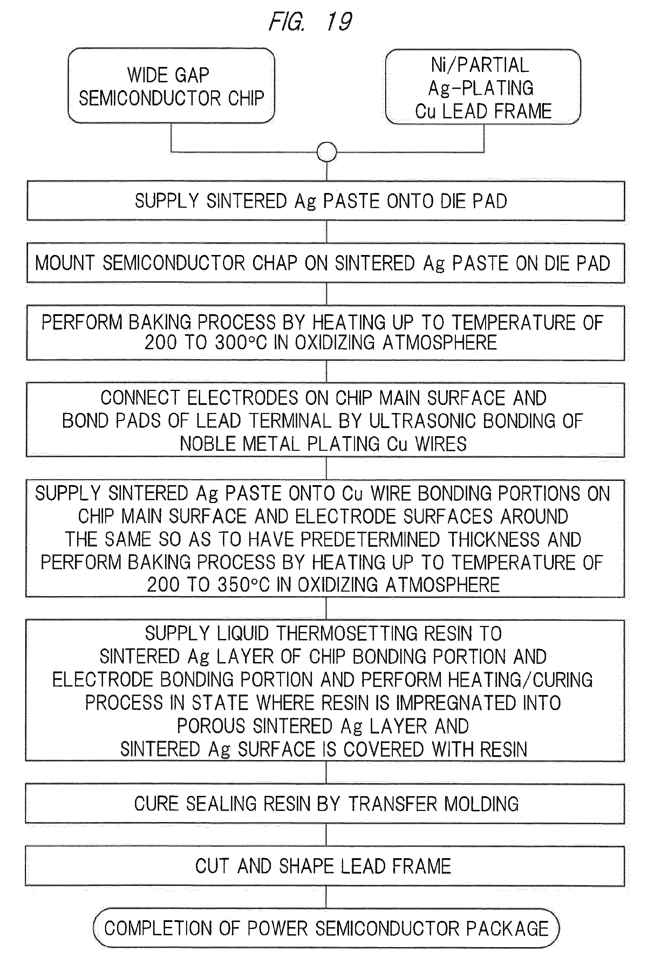

Next, assembling of the semiconductor package 35 of the second embodiment will be described. FIG. 19 is a flowchart showing one example of an assembling procedure of the semiconductor device shown in FIG. 15. Since the assembling of the semiconductor package 35 is almost identical to that of the semiconductor package 20 shown in FIG. 7, only a different point therebetween will be described with reference to FIG. 15, FIG. 16 and FIG. 19.

The different point between the assembling of the semiconductor package 35 of the second embodiment and the assembling of the semiconductor package 20 lies in the wire bonding process, the process of forming the sintered Ag layer on the chip, and the resin-applying and resin-curing process.

At the wiring bonding process in the assembling of the semiconductor package 35, first, the source electrode 2 positioned on the main surface 1a of the SiC chip 1 and having an outermost surface composed of a noble metal plating film such as an Ni/Au film or an Ag film and the source bond pad 8 of the source lead 9 to which an Ag plating 27 is applied are connected to each other by ultrasonic bonding by using an Ag wire or a thick copper wire 25 to which a noble metal plating film such as an Ag film is applied.

Further, the gate electrode 3 having an outermost surface composed of a noble metal plating film such as an Ni/Au film or an Ag film and the gate bond pad 10 of the gate lead 11 to which an Ag plating 27 is applied are connected to each other by ultrasonic bonding by using an Ag wire or a copper wire 26 which is thinner than the copper wire 25 and to which a noble metal plating film such as an Ag film is applied.

In this manner, also in the wire bonding of the semiconductor package 35, the source electrode 2 and the source lead 9 can be connected by using the copper wire 25, and further the gate electrode 3 and the gate lead 11 can be connected by using the copper wire 26.

After the wire bonding, the second sintered Ag paste 37 is supplied to 70% or more of a region of the main surface 1a of the SiC chip 1 including the wire bonding portion on the surface of the source electrode 2 and a surrounding area thereof, preferably to an approximately whole region of the surface so that it has a thickness of 50 µm or more. Further, the Ag paste is baked by heating it up to a temperature of 200 to 350°C in the atmosphere and holding the temperature for 0.5 to 2 hours. More specifically, the porous second sintered Ag layer 36 is formed on the source electrode 2 and the gate electrode 3.

At this time, resin in the Ag paste disappears due to volatilization, decomposition or flowage, and coupling and fusion between the remaining Ag particles and between the Ag particles and the noble metal film of the copper wire 25 or the electrode progresses, so that the second sintered Ag layer 36 forms a mesh-like network to reach the metal-bonded state with the noble metal film.

More specifically, the source electrode 2 of the SiC chip 1 and the copper wire 25 are electrically connected by the second sintered Ag layer 36, and the gate electrode 3 and the copper wire 26 are electrically connected by the second sintered Ag layers 36, respectively.

Next, liquid thermosetting resin (reinforcing resin 23) such as epoxy resin is supplied to the die pad 6, the bonding portion of the drain electrode 4 on the back surface 1b of the SiC chip 1, and the porous second sintered Ag layers 36 on the source electrode 2 and the gate electrode 3 on the main surface 1a of the SiC chip 1, thereby impregnating the thermosetting resin into the second sintered Ag layers 36 and covering the surface of the first sintered Ag layer 16 with the thermosetting resin.

In this state, the heating and curing process is performed to form the reinforcing resin portion 17 covering the surface of the first sintered Ag layer 16 of the die bond portion.

Since the other assembling of the semiconductor package 35 of the second embodiment is similar to that of the semiconductor package 20 of the first embodiment, the redundant description thereof is omitted.

According to the assembling of the semiconductor device of the second embodiment, although the die bonding process and the wire bonding process are different in heating temperature and output conditions of load and ultrasonic wave from the assembling of the conventional product, the same assembling process as that in the assembling of the conventional product can be used. Further, although the process of forming the sintered Ag layer of the wire bonding portion and the process of impregnating and curing the reinforcing resin are added, since no process which hinders the mass productivity is included therein, the high-reliability semiconductor package 35 can be manufactured with improved productivity by using the production line for the conventional products without requiring new equipment investment.

Since the other effect of the assembling of the semiconductor package 35 of the second embodiment is similar to that of the assembling of the semiconductor package 20 shown in FIG. 7 of the first embodiment, the redundant description thereof is omitted.

Next, a modified example of the second embodiment will be described.

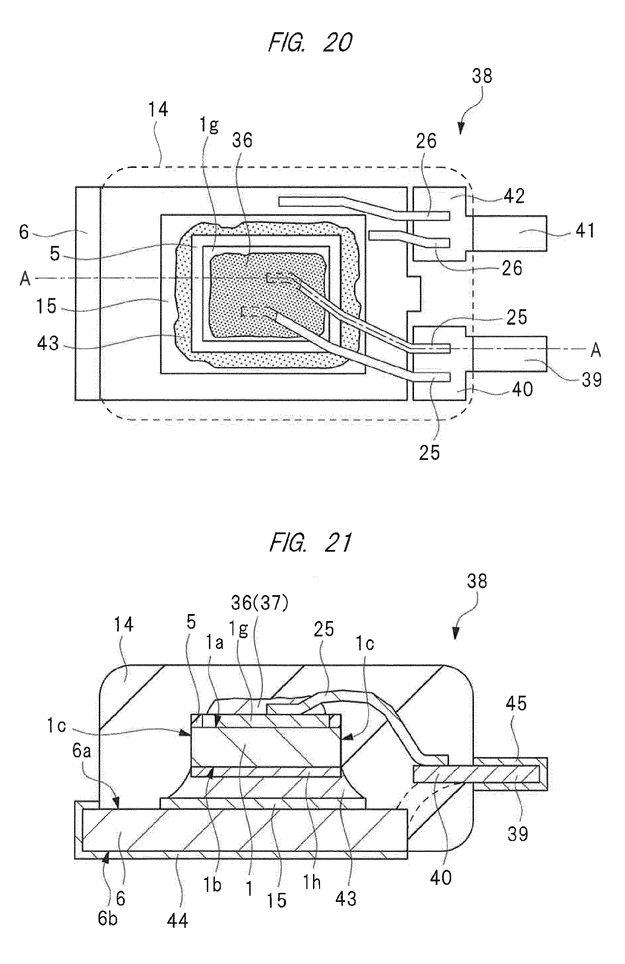

FIG. 20 is a plan view showing a structure of a semiconductor device of the modified example of the second embodiment while illustrating a resin portion in a transparent manner, and FIG. 21 is a sectional view showing a structure taken along a line A-A shown in FIG. 20.

The semiconductor device of the modified example of the second embodiment shown in FIG. 20 and FIG. 21 is a semiconductor package 38 of a SiC diode type.

The structure of the semiconductor package 38 will be described. First, a main electrode 1g having an outermost surface composed of a noble metal film is formed on a main surface 1a of an SiC chip 1 serving as the SiC diode device, and an insulating passivation film 5 is formed around the main electrode 1g so as to reach end portions of the SiC chip 1. On the other hand, a back surface electrode 1h composed of a multi-layered film having an outermost surface composed of a noble metal layer is formed on a back surface 1b.

Meanwhile, a Cu lead frame is composed of a die pad 6 on which the SiC chip 1 is mounted, a back surface electrode lead 41 and a back surface electrode bond pad 42 from which a current is taken to the outside, a main electrode lead 39, and a main electrode bond pad 40, and an Ag-plating film 15 is formed on a chip-mounting region of the die pad 6.

Further, an Ag-plating surface on the die pad 6 and the back surface electrode 1h of the SiC chip 1 are metal-bonded via a ZnAl-based, SnSbAgCu-based, or AuSn-based high-temperature Pb-free solder 43. More specifically, the SiC chip 1 is mounted on the die pad 6 via the high-temperature Pb-free solder 43.

Furthermore, the main electrode 1g of the SiC chip 1 and the main electrode bond pad 40 are connected by ultrasonic bonding by using a plurality of copper wires 25 whose surfaces are plated with Ag, Au or Pd, and the die pad 6 and the back surface electrode bond pad 42 are connected by ultrasonic bonding by using a plurality of copper wires 26 whose surfaces are plated with Ag, Au or Pd.

Also, on the main electrode 1g of the SiC chip 1, a porous second sintered Ag layer 36 having a thickness of 30 µm or more is formed on a region of 70% or more of the surface of the main electrode 1g, preferably an approximately whole region of the surface in a state where it covers parts of the copper wires 25.

More specifically, on the main electrode 1g, the wire bonding portions of the copper wires 25 and surrounding areas thereof and the approximately whole region of the surface of the main electrode 1g are covered with the second sintered Ag layer 36.

Note that the second sintered Ag layer 36 preferably covers the whole surface of the main electrode 1g, but it may be formed so as to cover an inner region other than the outer circumferential portion of the surface of the main electrode 1g as shown in FIG. 20. More specifically, since it is difficult to control the second sintered Ag layer 36 so as to cover all 100% of the surface of the main electrode 1g, the second sintered Ag layer 36 may be formed so as to cover the inner region other than the outer circumferential portion in order to prevent the protrusion from the outer circumferential portion of the surface.

Moreover, a sealing body 14 made of sealing resin by resin molding is provided so as to expose parts of the die pad 6 and respective leads to outside and further cover all of the SiC chip 1, the solder bonding layer (high-temperature Pb-free solder 43), the plurality of copper wires 25 and 26, and the second sintered Ag layer 36.

Also, Sn-based Pb-free solder films 44 and 45 are formed by plating on the lower surface 6b and other parts of the die pad 6 and metal surfaces of the respective leads exposed from the sealing body 14.

According to the semiconductor package 38 of the second embodiment, a low-loss and small-sized semiconductor package 38 of a diode type in which high reliability is maintained for a long period of time even in a high-temperature operation environment can be realized.

More specifically, since a path of a current supplied from the copper wires 25 can be secured by the second sintered Ag layer 36, a high-reliability semiconductor package 38 of a diode type in which product performance can be maintained for a long period of time can be realized.

In the foregoing, the invention made by the inventors of the present invention has been concretely described based on the embodiments. However, it is needless to say that the present invention is not limited to the foregoing embodiments and various modifications and alterations can be made within the scope of the present invention.

For example, in the above-described first embodiment (modified examples), the case where a noble metal plating film such as an Au film or an Ag film is formed on a surface of a copper wire adopted as a metal wire has been described, but the above-described noble metal plating film may be a Pb-plating film. Further, a GaN chip may be used instead of the SiC chips shown in the first embodiment (including modified examples) and the second embodiment.

## Claims

1. A semiconductor device comprising:
a chip-mounting portion having a chip-mounting surface;
a wide gap semiconductor chip having a main surface and a back surface on an opposite side thereof, having a first electrode formed on the main surface and a second electrode formed on the back surface, and mounted on the chip-mounting surface of the chip-mounting portion;
a porous first sintered Ag layer provided between the chip-mounting surface and the wide gap semiconductor chip and bonding the chip-mounting portion and the wide gap semiconductor chip;
a first resin portion covering a surface of the first sintered Ag layer and formed in a fillet shape;
a first lead electrically connected to the first electrode of the wide gap semiconductor chip; and
a second lead electrically connected to the second electrode of the wide gap semiconductor chip,
wherein the first resin portion covers a part of a side surface of the wide gap semiconductor chip.

2. A semiconductor device comprising:
a chip-mounting portion having a chip-mounting surface;
a wide gap semiconductor chip having a main surface and a back surface on an opposite side thereof, having a first electrode formed on the main surface and a second electrode formed on the back surface, and mounted on the chip-mounting surface of the chip-mounting portion;
a first lead electrically connected to the first electrode of the wide gap semiconductor chip;
a second lead electrically connected to the second electrode of the wide gap semiconductor chip;
a metal wire electrically connecting the first electrode and the first lead to each other; and
a porous second sintered Ag layer disposed on the first electrode and covering a wire bonding portion between the metal wire and the first electrode,
wherein the second sintered Ag layer covers a whole surface of the first electrode.

3. The semiconductor device according to claim 1, further comprising:
a metal wire electrically connecting the first electrode and the first lead to each other; and
a porous second sintered Ag layer disposed on the first electrode and covering a wire bonding portion between the metal wire and the first electrode,
wherein the second sintered Ag layer covers a whole surface of the first electrode.

4. The semiconductor device according to claim 1, further comprising:
an aluminum wire electrically connecting the first electrode and the first lead to each other.

5. The semiconductor device according to claim 1, further comprising:
an aluminum wire electrically connecting the first electrode and the first lead to each other; and
a second resin portion disposed on the first electrode and covering a wire bonding portion between the first electrode and the aluminum wire.

6. The semiconductor device according to claim 3,
wherein a first noble metal plating film is formed on the chip-mounting surface of the chip-mounting portion.

7. The semiconductor device according to claim 6,
wherein the wide gap semiconductor chip, the first sintered Ag layer or the first and second sintered Ag layers, the first resin portion, and a part of the chip-mounting portion are covered with a third resin portion.

8. The semiconductor device according to claim 1,
wherein an organic Zn film is formed at an interface between the first sintered Ag layer and the first resin portion.

9. The semiconductor device according to claim 7, further comprising:
the metal wire electrically connecting the first electrode and the first lead,
wherein a surface of the metal wire is covered with a second noble metal plating film.

10. The semiconductor device according to claim 9,
wherein the chip-mounting portion and the first and second leads are made of a material containing copper as a main component.

11. The semiconductor device according to claim 10,
wherein respective surfaces of the chip-mounting portion and the first and second leads are covered with an Ni-plating film.

12. The semiconductor device according to claim 1,
wherein the wide gap semiconductor chip is made of SiC or GaN.

13. The semiconductor device according to claim 1,
wherein a third electrode is formed on the main surface of the wide gap semiconductor chip,
a third lead electrically connected to the third electrode is provided,
the first lead is a source lead,
the second lead is a drain lead, and
the third lead is a gate lead.

14. A manufacturing method of a semiconductor device comprising:
(a) a step of preparing a lead frame provided with a chip-mounting portion having a chip-mounting surface, a first lead disposed in the vicinity of the chip-mounting portion, and a second lead coupled to the chip-mounting portion;
(b) a step of supplying first sintered Ag paste onto the chip-mounting surface of the chip-mounting portion and then mounting a wide gap semiconductor chip having a first electrode formed on a main surface thereof and a second electrode formed on a back surface thereof on the first sintered Ag paste;
(c) a step of heating the first sintered Ag paste to form a porous first sintered Ag layer and bonding the chip-mounting portion and the wide gap semiconductor chip by the first sintered Ag layer;
(d) a step of electrically connecting the first electrode of the wide gap semiconductor chip and the first lead to each other;
(e) a step of supplying first liquid resin onto a surface of the first sintered Ag layer and then heating the first resin, thereby forming a first resin portion covering the surface of the first sintered Ag layer and having a fillet shape; and
(f) a step of separating the first and second leads from the lead frame,
wherein, at the step (e), the first resin portion is formed so as to cover a part of a side surface of the wide gap semiconductor chip.

15. A manufacturing method of a semiconductor device comprising:
(a) a step of preparing a lead frame provided with a chip-mounting portion having a chip-mounting surface, a first lead disposed in the vicinity of the chip-mounting portion, and a second lead coupled to the chip-mounting portion;
(b) a step of mounting a wide gap semiconductor chip having a first electrode formed on a main surface thereof and a second electrode formed on a back surface thereof on the chip-mounting surface of the chip-mounting portion;
(c) a step of connecting the first electrode of the wide gap semiconductor chip and the first lead to each other by a metal wire;
(d) a step of supplying second sintered Ag paste to a wire bonding portion of the metal wire on the first electrode and then heating the second sintered Ag paste to form a porous second sintered Ag layer, thereby electrically connecting the first electrode and the metal wire via the second sintered Ag layer; and
(e) a step of separating the first and second leads from the lead frame,
wherein, at the step (d), the second sintered Ag layer is formed so as to cover a whole surface of the first electrode.

16. The manufacturing method of a semiconductor device according to claim 14,
wherein, at the step (d), the first electrode and the first lead are electrically connected to each other by a metal wire,
after the step (e) and before the step (f), a step of supplying second sintered Ag paste to a wire bonding portion of the metal wire on the first electrode and then heating the second sintered Ag paste to form a porous second sintered Ag layer, thereby electrically connecting the first electrode and the metal wire to each other via the second sintered Ag layer is provided, and
the second sintered Ag layer is formed so as to cover a whole surface of the first electrode.

17. The manufacturing method of a semiconductor device according to claim 14,
wherein, at the step (d), the first electrode and the first lead are electrically connected to each other by an aluminum wire.

18. The manufacturing method of a semiconductor device according to claim 14,
wherein, at the step (d), the first electrode and the first lead are electrically connected to each other by an aluminum wire, and
at the step (e), a second resin is supplied to a wire bonding portion of the aluminum wire on the first electrode and the second resin is then heated to form a second resin portion covering the wire bonding portion.

19. The manufacturing method of a semiconductor device according to claim 14,
wherein, after the step (d) and before the step (e), organic Zn compound solution is supplied onto a part of the chip-mounting portion and the first sintered Ag layer, and the organic Zn compound solution is then heated, thereby forming an organic Zn film on a part of the chip-mounting portion and a surface of the first sintered Ag layer.
